# EUROPEAN PATENT APPLICATION

(11) **EP 4 590 098 A1**
(43) Date of publication of application: **23.07.2025**
(21) Application number: 23865376.0
(22) Date of filing: 06.09.2023
(51) Int. Cl.: H10K 30/50, H01L 31/0224, H10K 30/40, H10K 30/81

(54) **SOLAR CELL ELEMENT AND SOLAR CELL MODULE**

(30) Priority: 13.09.2022 JP 2022145444
(71) Applicant: Kyocera Corporation, Kyoto-shi, Kyoto 612-8501 (JP)
(72) Inventor: SANO, Hirotaka, Kyoto-shi, Kyoto 612-8501 (JP)
(74) Representative: TBK
(86) International application number: PCT/JP2023/032490
(87) International publication number: WO 2024/058021

(57) **Abstract**

A solar cell device includes a solar cell unit (103), an electrode (101), and a first diffusion reducer (102). The solar cell unit (103) includes a light-receiving surface (F1). The first diffusion reducer (102) is located between the solar cell unit (103) and the electrode (101). The first diffusion reducer (102) includes a first surface (F3) on the light-receiving surface (F1) and a second surface (F4) on the electrode (101). In a plan view of the light-receiving surface (F1), the first diffusion reducer (102) is located in an area other than at least part of an area not overlapping the electrode (101).

## Description

### CROSS-REFERENCE TO RELATED APPLICATION

This application claims priority to Japanese Patent Application No. 2022-145444 filed on September 13, 2022, the entire disclosure of which is incorporated herein by reference.

### TECHNICAL FIELD

The present disclosure relates to a solar cell device and a solar cell module.

### BACKGROUND OF INVENTION

A solar cell device includes a semiconductor that generates electricity in response to incident light, a transparent electrode film on a light-receiving surface of a solar cell unit, and a current-collecting electrode on the transparent electrode film (e.g., Patent Literature 1). Such a solar cell device is known to include the transparent electrode film as an interface layer to reduce deterioration resulting from diffusion between the current-collecting electrode and the semiconductor (e.g., Patent Literature 2).

### CITATION LIST

### PATENT LITERATURE

Patent Literature 1: Japanese Unexamined Patent Application Publication No. 2002-76385
Patent Literature 2: Japanese Unexamined Patent Application Publication No. 2015-122435

### SUMMARY

Solar cell devices are to be improved to achieve both higher reliability and less decrease in power generation efficiency.

In one aspect, a solar cell device includes a solar cell unit, an electrode, and a first diffusion reducer. The solar cell unit includes a light-receiving surface. The first diffusion reducer is between the solar cell unit and the electrode. The first diffusion reducer includes a first surface on the light-receiving surface and a second surface on the electrode. In a plan view of the light-receiving surface, the first diffusion reducer is located in an area other than at least part of an area not overlapping the electrode.

In one aspect, a solar cell device includes a solar cell unit, an electrode, and a first diffusion reducer. The solar cell unit includes a light-receiving surface. The first diffusion reducer is between the solar cell unit and the electrode. The first diffusion reducer includes a first surface on the light-receiving surface, a second surface on the electrode, and a third surface opposite to the first surface. The third surface is located in at least part of an area not overlapping the electrode in a plan view of the light-receiving surface. The first diffusion reducer has a smaller thickness between the first surface and the third surface than between the first surface and the second surface.

In one aspect, a solar cell module includes a solar cell unit including a light-receiving surface. The solar cell module includes a first diffusion reducer on the light-receiving surface. The first diffusion reducer includes a first surface in contact with the light-receiving surface, a second surface opposite to the first surface, and a third surface different from the second surface. The solar cell module includes an electrode on the second surface. The first diffusion reducer includes a first portion having a thickness from the first surface to the second surface, and a second portion having a thickness from the first surface to the third surface. The second portion has a smaller thickness than the first portion.

The solar cell device and the solar cell module can achieve both higher reliability and less decrease in power generation efficiency.

### BRIEF DESCRIPTION OF THE DRAWINGS

FIG. 1 is a partial perspective view of a solar cell device 10 according to a first embodiment.
FIG. 2 is a partial top view of the solar cell device 10 according to the first embodiment.
FIG. 3 is an end view of the solar cell device 10 according to the first embodiment taken along cross section III-III in FIG. 2.
FIG. 4 is a partial enlarged view of the solar cell device 10 according to the first embodiment in FIG. 3.
FIG. 5 is a diagram of a solar cell device 10 according to a variation of the first embodiment.
FIG. 6 is a diagram of an example of the solar cell device 10 according to the first embodiment.
FIG. 7 is a diagram of an example of the solar cell device 10 according to the first embodiment.
FIG. 8 is a diagram of an example of the solar cell device 10 according to the first embodiment.
FIG. 9 is a diagram of an example of the solar cell device 10 according to the first embodiment.
FIG. 10 is a flowchart of a method for manufacturing the solar cell device 10 according to the first embodiment.
FIG. 11 is a cross-sectional view of a solar cell module 1 according to the first embodiment.
FIG. 12 is a cross-sectional view of a solar cell module 2 according to a second embodiment.
FIG. 13 is a diagram of a solar cell device 30 according to a third embodiment.
FIG. 14 is a diagram of a solar cell device 40 according to a fourth embodiment.
FIG. 15 is a diagram of a solar cell device 50 according to a fifth embodiment.
FIG. 16 is a diagram of a solar cell device 60 according to a sixth embodiment.
FIG. 17 is a diagram of a solar cell module 6 according to the sixth embodiment.
FIG. 18 is a diagram of a solar cell device 70 according to a seventh embodiment.
FIG. 19 is a diagram of a solar cell module 7 according to the seventh embodiment.

### DESCRIPTION OF EMBODIMENTS

A solar cell device includes, on a light-receiving surface on which the solar cell device receives light, a first electrode for collecting electricity from a solar cell unit that generates electric power in response to incident light.

Such a solar cell device is known to show lower power generation efficiency after a period of use. A known factor that reduces power generation efficiency is, for example, the diffusion of the material for the solar cell unit into the first electrode or the diffusion of the material for the first electrode into the solar cell unit.

For example, a diffusion reducer between the first electrode and the solar cell unit may reduce the likelihood of lower power generation efficiency caused by the diffusion between the first electrode and the solar cell unit. In other words, a diffusion reducer between the first electrode and the solar cell unit is expected to improve the reliability of the solar cell device.

However, a diffusion reducer between the first electrode and the solar cell unit absorbs sunlight and reduces the amount of received sunlight that contributes to power generation in the solar cell unit. In other words, the diffusion reducer may reduce the power generation efficiency of the solar cell device.

Thus, solar cell devices are to be improved to achieve both higher reliability and less decrease in power generation efficiency. The same issue applies to solar cell modules that include solar cell devices.

The inventor of the present disclosure has developed a technique for improving the power generation efficiency and the reliability of solar cell devices and solar cell modules. First to seventh embodiments associated with the technique will now be described with reference to the drawings.

The embodiments will now be described with reference to the drawings. In the drawings, the same reference numerals denote the components with the same or similar structures and functions, and such components will not be described repeatedly. The drawings are schematic. Each figure illustrates a right-handed XYZ coordinate system. In the XYZ coordinate system, a direction normal to a light-receiving surface F1 of a solar cell device 10 is defined as a positive Z-direction, one direction parallel to the light-receiving surface F1 is defined as a positive X-direction, and a direction parallel to the light-receiving surface F1 and perpendicular to both the positive X-direction and the positive Z-direction is defined as a positive Y-direction. The positive Z-direction hereafter refers to an upward direction unless otherwise specified.

### First Embodiment

### 1-1. Solar Cell Device 10

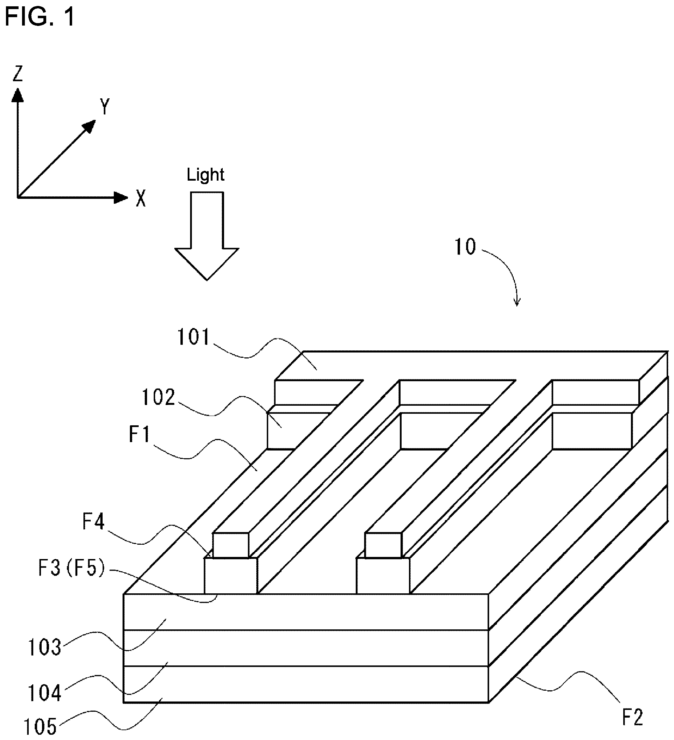

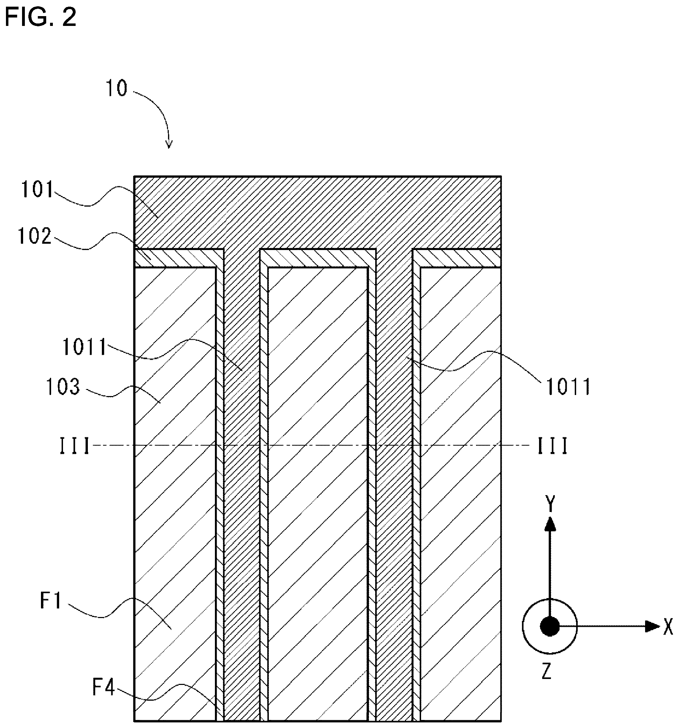

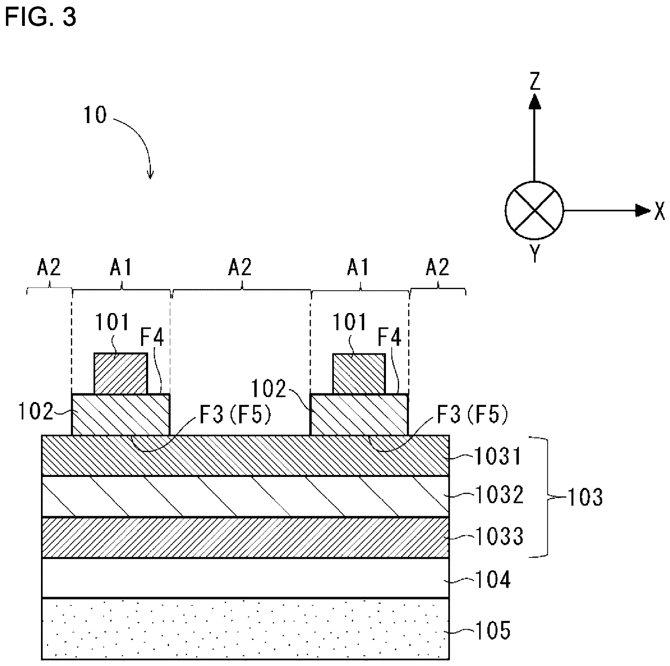

The solar cell device 10 according to a first embodiment will now be described with reference to FIGs. 1 to 3. FIG. 1 is a partial perspective view of the solar cell device 10 according to the first embodiment. FIG. 2 is a partial top view of the solar cell device 10 according to the first embodiment, illustrating the light-receiving surface F1. FIG. 3 is a cross-sectional view taken along line III-III in FIG. 2. More specifically, FIG. 3 is a cross-sectional view taken along a cross section perpendicular to a longitudinal direction of a first electrode 101. Note that FIGs. 1 and 2 illustrate a portion of the solar cell device 10 cut out from the entire solar cell device 10.

As illustrated in FIG. 1, the solar cell device 10 includes the light-receiving surface F1 that mainly receives light and a back surface F2 opposite to the light-receiving surface F1. In the first embodiment, the light-receiving surface F1 faces in the positive Z-direction. The back surface F2 faces in a negative Z-direction. For example, the positive Z-direction may be set to a direction toward the sun culminating in the south.

As illustrated in FIG. 3, the solar cell device 10 includes the first electrode 101, a first diffusion reducer 102, a solar cell unit 103, a second electrode 104, and a substrate 105. As illustrated in FIG. 3, the solar cell unit 103 includes a first carrier transporter 1031, a photoelectric converter 1032, and a second carrier transporter 1033. In the first embodiment, the second electrode 104, the second carrier transporter 1033, the photoelectric converter 1032, the first carrier transporter 1031, the first diffusion reducer 102, and the first electrode 101 are stacked in this order on the substrate 105.

Although not illustrated, note that a solar cell module 1 (described later) may include an anti-reflective film on a front surface of the solar cell module 1. The anti-reflection film may be an insulating film of, for example, silicon nitride. Although not illustrated, a passivation film may be located between the first electrode 101 and the anti-reflective film, between the first diffusion reducer 102 and the anti-reflective film, or between the solar cell unit 103 and the anti-reflective film. The passivation film may be a thin film of, for example, an oxide such as aluminum oxide or a nitride.

Multiple solar cell devices 10 can be connected to one another to form the solar cell module 1. For example, multiple solar cell devices 10 may be connected to form a solar cell module 1 having a size of about 1 m square. Multiple solar cell modules 1 may be connected to one another to form a solar cell string. Multiple solar cell strings may be connected to one another to form a solar cell array.

The components of the solar cell device 10 will now be described. For ease of explanation, the components will be described sequentially from the substrate 105.

### 1-1-1. Substrate 105

The substrate 105 is a base for the components (e.g., the solar cell unit 103) of the solar cell device 10. The material for the substrate 105 may be, for example, glass, a plastic material such as acryl or polycarbonate, or a metal such as stainless steel. The substrate 105 may be, for example, a flat plate, a sheet, or a film. The substrate 105 may have a thickness of, for example, about 0.01 to 5 millimeters (mm).

### 1-1-2. Second Electrode 104

The second electrode 104 is located on the substrate 105. The second electrode 104 can collect carriers resulting from photoelectric conversion in response to light incident on the solar cell unit 103 (described later). The second electrode 104 can serve as, for example, an electrode that collects electrons as carriers (also referred to as a negative electrode). The material for the second electrode 104 may be, for example, a highly conductive metal such as silver (Ag), gold (Au), copper (Cu), titanium (Ti), indium (In), or tin (Sn).

The material for the second electrode 104 may also be, for example, a transparent conductive oxide (TCO) that transmits light in a specific wavelength range. The second electrode 104 may have a thickness of, for example, about 10 to 1000 nanometers (nm). The second electrode 104 may be formed on the substrate 105 with, for example, a vacuum process such as sputtering.

For example, the TCO may be, but is not limited to, indium tin oxide (ITO), aluminum-doped zinc oxide (AZO), boron-doped zinc oxide (BZO), gallium-doped zinc oxide (GZO), fluorine-doped tin oxide (FTO), antimony-doped tin oxide (ATO), titanium-doped indium oxide (ITiO), indium zinc oxide (IZO), indium gallium zinc oxide (IGZO), tantalum-doped tin oxide (SnO₂:Ta), niobium-doped tin oxide (SnO₂:Nb), tungsten-doped tin oxide (SnO₂:W), molybdenum-doped tin oxide (SnO₂:Mo), fluorine-doped tin oxide (SnO₂:F), or hydrogen-doped indium oxide (IOH). The transparent conductive oxide film may be a stack of films. The stack of films may include a film of, for example, tin oxide in addition to the oxides listed above. The dopant for the film of, for example, tin oxide may be, but is not limited to, at least one selected from the group consisting of, for example, In, silicon (Si), germanium (Ge), Ti, Cu, antimony (Sb), Nb, F, Ta, W, Mo, bromine (Br), iodine (I), and chlorine (Cl).

### 1-1-3. Solar Cell Unit 103

The solar cell unit 103 is located on the second electrode 104. The solar cell unit 103 converts external light (e.g., sunlight) incident on the solar cell unit 103 to electric power. For example, the solar cell unit 103 may generate carriers through photoelectric conversion in response to light illumination. The carriers include electrons, holes, or both. The solar cell unit 103 includes the first light-receiving surface F1.

In the first embodiment, the first carrier transporter 1031 as a p-type semiconductor, the photoelectric converter 1032 as an i-type semiconductor, and the second carrier transporter 1033 as an n-type semiconductor define a PIN junction. The PIN junction may allow photoelectric conversion in response to light illumination to generate electric power.

In the first embodiment described below, the solar cell unit 103 is a perovskite solar cell. However, this is a mere example, and other types of solar cells may be used. For example, the solar cell may be an inorganic solar cell or an organic solar cell. The inorganic solar cell may be a silicon solar cell or a compound solar cell. The organic solar cell may be a dye-sensitized solar cell or an organic thin-film solar cell. The solar cell may be, for example, a crystalline solar cell or a thin-film solar cell. The crystalline solar cell may be a silicon solar cell or a compound semiconductor solar cell such as a CIGS solar cell. The thin-film solar cell may be a perovskite solar cell, a dye-sensitized solar cell, or an organic thin-film solar cell.

As illustrated in FIG. 3, the solar cell unit 103 includes the first carrier transporter 1031, the photoelectric converter 1032, and the second carrier transporter 1033. In the first embodiment, the second carrier transporter 1033, the photoelectric converter 1032, and the first carrier transporter 1031 are stacked in this order on the second electrode 104.

The components of the solar cell unit 103 will now be described. For ease of explanation, the components will be described sequentially from the second carrier transporter 1033.

The second carrier transporter 1033 is located on the second electrode 104. The second carrier transporter 1033 may be, for example, a semiconductor of an inorganic material (also referred to as an inorganic semiconductor) having higher electric resistance than the second electrode 104. This reduces electrical contact between the second electrode 104 and the photoelectric converter 1032.

In the first embodiment, the material for the inorganic semiconductor may be, for example, a semiconductor of n-type conductivity (also referred to as an n-type semiconductor). In this case, the second carrier transporter 1033 functions as, for example, a hole blocking layer or an electron transport layer (ETL). The electron transport layer collects and outputs, for example, electrons.

The n-type semiconductor may be [6,6]-phenyl-C-61-butyric acid methyl ester (PCBM), C60, or an oxide semiconductor layer. The oxide semiconductor layer may be, for example, titanium(IV) oxide (TiO₂), zinc oxide (ZnO), indium(III) oxide (In₂O₃), tin(IV) oxide (SnO₂), or magnesium oxide (MgO).

The photoelectric converter 1032 is located on the second carrier transporter 1033. The photoelectric converter 1032 can absorb light through the first diffusion reducer 102 and the first carrier transporter 1031 (described later). In the first embodiment, the photoelectric converter 1032 is, for example, an intrinsic semiconductor (also referred to as an i-type semiconductor). The i-type semiconductor may be a semiconductor with a perovskite structure (also referred to as a perovskite semiconductor). The perovskite semiconductor may include, for example, an organic and inorganic halide perovskite semiconductor. The organic and inorganic halide perovskite semiconductor is a semiconductor with a perovskite structure of a composition of ABX3. A is, for example, an ion of at least one selected from the group consisting of methylammonium (CH₃NH₃), formamidinium (CH(NH₂)₂), cesium (Cs), rubidium (Rb), and potassium (K). B is, for example, an ion of at least one selected from the group consisting of lead (Pb) and tin (Sn). X is, for example, an ion of at least one selected from the group consisting of iodine (I), bromine (Br), and chlorine (Cl). More specifically, the semiconductor with the perovskite structure of the ABX3 composition may include, for example, organic perovskite such as CH₃NH₃PbI₃ or (CH(NH₂)₂,Cs)Pb(I,Br)₃. The organic perovskite may be formed by, for example, applying a first liquid material onto the second carrier transporter 1033 and drying the applied first liquid material. In this example, the organic perovskite is a crystalline thin film. The first liquid material may be prepared by, for example, dissolving alkyl halide amine and lead halide as the materials in a solvent. The photoelectric converter 1032 may have a thickness of, for example, about 100 to 2000 nm.

The first carrier transporter 1031 is located on the photoelectric converter 1032. The surface of the first carrier transport layer 1031 opposite to the photoelectric converter 1032 may be the light-receiving surface F1. In the first embodiment, for example, the first carrier transporter 1031 may be a semiconductor having p-type conductivity (also referred to as a p-type semiconductor). In this case, the first carrier transporter 1031 functions as, for example, an electron blocking layer or a hole transport layer (HTL). For example, the HTL collects and outputs holes.

The material for the HTL may be, for example, 2,2',7,7'-tetrakis-(N,N-di-p-methoxyphenylamino)-9,9'-spirobifluorene (spiro-OMeTAD), which is a derivative of soluble diamine. The HTL may be formed by, for example, applying a second liquid material onto a layer of a perovskite semiconductor as the photoelectric converter 1032 and drying the applied second liquid material. The carrier transport layer may have a thickness of, for example, about 50 to 200 nm.

The p-type semiconductor may be, for example, nickel(II) oxide (NiO), copper(I) thiocyanate (CuSCN), copper(I) oxide (Cu₂O), or an organic semiconductor layer. The organic semiconductor layer may be, for example, spiro-OMeTAD, poly[bis(4-phenyl)(2,4,6-trimethylphenyl)amine] (PTAA), poly(3-hexylthiophene-2,5-diyl) (P3HT), or poly(3,4-ethylenedioxythiophene)/poly(4-styrenesulfonate) (PEDOT/PSS).

### 1-1-4. First Diffusion Reducer 102

The first diffusion reducer 102 is located on the solar cell unit 103. In other words, the first diffusion reducer 102 is located on the light-receiving surface F1 of the solar cell unit 103. In still other words, the first diffusion reducer 102 is located between the first electrode 101 and the solar cell unit 103. The first diffusion reducer 102 may include a first surface F3 in contact with the light-receiving surface F1 of the solar cell unit 103 and a second surface F4 opposite to the first surface F3. The first surface F3 is a surface of the first diffusion reducer 102 facing the solar cell unit 103. The second surface F4 is a surface of the first diffusion reducer 102 facing the first electrode 101. The second surface F4 is also opposite to the first surface F3 in the thickness direction of the solar cell unit 103. The first surface F3 and the second surface F4 may be, for example, flat.

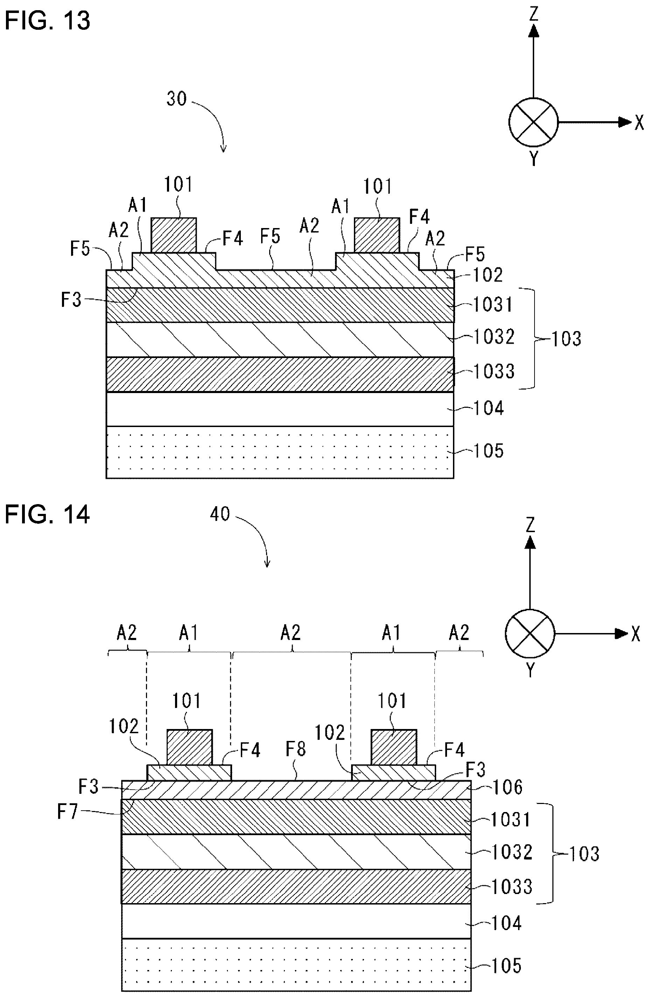

In the example in FIG. 1, the first diffusion reducer 102 has a third surface F5 aligned with the first surface F3. More specifically, the third surface F5 may be at the same position as the first surface F3 in the positive Z-direction. As described in detail with reference to FIG. 13 in a third embodiment (described later), the third surface F5 may be different from the first surface F3 and the second surface F4. As illustrated in FIG. 13, the third surface F5 may be located between the position of the first surface F3 in the positive Z-direction and the position of the second surface F4 in the positive Z-direction. The third surface F5 is located in at least part of an area not overlapping the first electrode 101 in a plan view of the light-receiving surface F1. In FIG. 13, the third surface F5 may be regarded as a single surface, or may be a set of surfaces of the first diffusion reducer 102 parallel to the first surface F3 and the second surface F4. For example, the third surface F5 may be regarded as a set of surfaces of the first diffusion reducer 102 located between, in the positive Z-direction, the position of the third surface F5 in the positive Z-direction and the position of the first surface F3 in the positive Z-direction. In the example in FIG. 13, the third surface F5 may be parallel to the first surface F3 and the second surface F4.

FIGs. 1 to 3 may be figures illustrating the solar cell device 10 including a second portion A2 (described later) with a thickness of zero. As illustrated in FIGs. 1 and 3, the third surface F5 (the first surface F3 in this example) may be parallel to the second surface F4.

The thickness of the first diffusion reducer 102 hereafter refers to the thickness in the positive Z-direction. In other words, the thickness of the first diffusion reducer 102 may be regarded as the thickness in the direction from the first surface F3 to the second surface F4. The same thickness definition as the first diffusion reducer 102 applies to the thickness of a first portion A1 or the second portion A2 (described later).

The material for the first diffusion reducer 102 may be a conductive inorganic material. For example, a conductive oxide or a conductive nitride may be used. The first diffusion reducer 102 may be formed on the first carrier transporter 1031 with, for example, a vacuum process. The vacuum process may be, for example, sputtering, chemical vapor deposition (CVD), vacuum vapor deposition, or atomic layer deposition (ALD). The first diffusion reducer 102 may have a thickness of, for example, about 1 to 100 nm.

The first diffusion reducer 102 is an interface layer between the first electrode 101 and the solar cell unit 103. The interface layer between the upper portion and the lower portion refers to an intermediate layer including an upper surface in contact with the upper portion and a lower surface in contact with the lower portion. For example, the first diffusion reducer 102 functions as a diffusion barrier film. When the first electrode 101 is located directly on the light-receiving surface F1, the metal in the first electrode 101 may diffuse into the first carrier transporter 1031 or the photoelectric converter 1032, degrading the first carrier transporter 1031 or the photoelectric converter 1032. In another case, the molecules in the first carrier transporter 1031 or the photoelectric converter 1032 may diffuse into the first electrode 101, degrading the first electrode 101. These may lower the conversion efficiency of the solar cell device 10. Thus, the first diffusion reducer 102 may be located between the first carrier transporter 1031 and the first electrode 101 to reduce lower conversion efficiency of the solar cell device 10 resulting from diffusion. More specifically, the first diffusion reducer 102 reduces at least one of the amount of metal migrating from the first electrode 101 to the first carrier transporter 1031 or the amount of metal migrating from the first carrier transporter 1031 to the first electrode 101.

The first diffusion reducer 102 includes the first portion A1 and the second portion A2. The first portion A1 is a portion of the first diffusion reducer 102 with a thickness from the first surface F3 to the second surface F4. As easily understandable from FIG. 13, the second portion A2 is a portion of the first diffusion reducer 102 with a thickness from the first surface F3 to the third surface F5. When, for example, the third surface F5 in the positive Z-direction is located between the position of the first surface F3 in the positive Z-direction and the position of the second surface F4 in the positive Z-direction, the first portion A1 is thicker than the second portion A2. The first diffusion reducer 102 may include the first portion A1 and the second portion A2 that is thinner than the first portion A1. In other words, the first diffusion reducer 102 may be regarded as including the second portion A2 and the first portion A1 that is thicker than the second portion A2. More specifically, the first diffusion reducer 102 may be regarded as including the first portion A1 that is relatively thick and the second portion A2 that is relatively thin.

The second portion A2 may have a thickness of zero (refer also to FIG. 1). In other words, the third surface F5 and the first surface F3 may be aligned with each other, instead of being parallel to each other. In this case, the second portion A2 is a portion of the first diffusion reducer 102 not covering the light-receiving surface F1 of the solar cell unit 103. In other words, the second portion A2 corresponds to an exposed portion of the light-receiving surface F1 of the solar cell unit 103 in a plan view of the solar cell device 10. Note that the exposed portion refers to, for example, a portion of the light-receiving surface F1 of the solar cell unit 103 exposed from the first diffusion reducer 102. In other words, a transparent layer different from the first diffusion reducer 102 may be located on the exposed portion of the light-receiving surface F1 of the solar cell unit 103.

In other words, the light-receiving surface F1 of the solar cell unit 103 may be regarded as including the first portion A1 covered by the first diffusion reducer 102 and the second portion A2 not covered by the first diffusion reducer 102. In this case, in a plan view of the light-receiving surface F1 of the solar cell device 10, the first electrode 101 or the first diffusion reducer 102 is viewed in the first portion A1, whereas the light-receiving surface F1 of the solar cell unit 103 is viewed in the second portion A2. More specifically, in a plan view of the light-receiving surface F1 of the solar cell device 10, the light-receiving surface F1 of the solar cell unit 103 is exposed in the second portion A2. In other words, the first diffusion reducer 102 is located in an area other than at least part of the area not overlapping the first electrode 101 in a plan view of the light-receiving surface F1. In a specific example, the first electrode 101 may include multiple elongated portions 1011 extending in a predetermined longitudinal direction in a plan view of the light-receiving surface F1 (refer to FIG. 2). The elongated portions 1011 may be at an interval in a direction intersecting with the longitudinal direction. For example, the first diffusion reducer 102 may be located in an area other than at least part of the area between the elongated portions 1011.

Note that, as illustrated in FIG. 13, the second portion A2 may have a uniform thickness across the first diffusion reducer 102. In this case, the third surface F5 is at a constant position in the positive Z-direction across the first diffusion reducer 102. In other words, the third surface F5 has a constant height in the positive Z-direction from the first surface F3 across the first diffusion reducer 102. The second portion A2 with the uniform thickness across the first diffusion reducer 102 simplifies the manufacturing process of the solar cell device 10.

The second portion A2 may have multiple thicknesses in the first diffusion reducer 102. For example, the second portion A2 may include a sub-portion with a first thickness and a sub-portion with a second thickness. In other words, the third surface F5 may be at multiple positions in the positive Z-direction in the first diffusion reducer 102. For example, the third surface F5 may include a portion with the distance between the first surface F3 and the third surface F5 equal to the first thickness and a portion with the distance between the first surface F3 and the third surface F5 equal to the second thickness. Note that the first thickness or the second thickness may be zero or may be the same as the thickness between the first surface F3 and the second surface F4. The second portion A2 having multiple thicknesses in the first diffusion reducer 102 includes a thick portion and a thin portion. This reduces the manufacturing cost of the solar cell device 10 for a thinner portion of the second portion A2.

The first electrode 101 (described later) is located on the first portion A1. More specifically, the first electrode 101 (described later) is located on the second surface F4 in the first portion A1. In other words, the portion of the first diffusion reducer 102 on which the first electrode 101 is located (first portion A1) and the portion of the first diffusion reducer 102 on which the first electrode 101 is not located (second portion A2) may be regarded as having different thicknesses. In the first embodiment, for example, the portion of the first diffusion reducer 102 on which the first electrode 101 located has a thickness larger than the thickness (= 0) of the portion of the first diffusion reducer 102 on which the first electrode 101 is not located.

Note that, when the second portion A2 has a thickness of zero, the first electrode 101 (described later) is located on the first portion A1. In this case, the first electrode 101 may be regarded as being located on the first diffusion reducer 102.

In the above structure, the portion of the solar cell unit 103 below the first electrode 101 receives no incident light. Thus, the light incident on the photoelectric converter 1032 remains largely unchanged for a larger thickness of the first diffusion reducer 102. The first diffusion reducer 102 with a larger thickness can reduce the likelihood that the molecules of one of the first electrode 101 or the solar cell unit 103 diffuse to the other. More specifically, the structure in which the first electrode 101 is located on the first portion A1 of the first diffusion reducer 102 alone can enhance the diffusion reduction through the first diffusion reducer 102 without greatly changing the amount of light received by the solar cell unit 103.

In the solar cell device 10, the second portion A2 may be thinner than the first portion A1. In this case, the third surface F5 of the first diffusion reducer 102 is located between, in the positive Z-direction, the position of the first surface F3 in the positive Z-direction and the position of the second surface F4 in the positive Z-direction. This structure can reduce the attenuation of light incident on the solar cell unit 103 when the light passes through the second portion A2 of the first diffusion reducer 102. More specifically, the solar cell unit 103 including the second portion A2 thinner than the first portion A1 can receive more incident light than when including the first portion A1 and the second portion A2 having the same thickness. The solar cell device 10 can thus have higher power generation efficiency.

For example, the second portion A2 may have a thickness of zero. More specifically, the first diffusion reducer 102 may not be located in at least part of the area in which the first electrode 101 is not located. More specifically, in a plan view of the light-receiving surface F1 of the solar cell device 10, the first diffusion reducer 102 may be shaped to allow viewing of the solar cell unit 103 in the area not including the first electrode 101. In other words, when the third surface F5 is aligned with the first surface F3 instead of being parallel to the first surface F3, the first diffusion reducer 102 may not be located in at least part of the area in which the first electrode 101 is not located. More specifically, in a plan view of the first electrode 101 in the solar cell device 10, the first diffusion reducer 102 may be shaped to allow viewing of the light-receiving surface F1 of the solar cell unit 103 in the second portion A2.

The above structure can reduce light absorption loss through the first diffusion reducer 102 in the second portion A2. More specifically, more light can pass through the second portion A2 and be incident on the photoelectric converter 1032. This increases light incident on the photoelectric converter 1032, thus improving the conversion efficiency of the solar cell device 10.

When the second portion A2 has a thickness of zero, the material for the first diffusion reducer 102 may include a material with the absorption wavelength overlapping the absorption wavelength of the photoelectric converter 1032. More specifically, the material for the first diffusion reducer 102 may include a material that does not transmit the absorption wavelength of the photoelectric converter 1032.

In the above structure, the portion of the solar cell unit 103 below the first electrode 101 receives no incident light. Thus, the light incident on the photoelectric converter 1032 remains largely unchanged although the portion of the first diffusion reducer 102 below the first electrode 101 has the same absorption wavelength as the photoelectric converter 1032. With less strict conditions for the absorption wavelength, more material options are available for the first diffusion reducer 102. For the second portion A2 with a thickness of zero, the material for the first diffusion reducer 102 may include a material with the absorption wavelength overlapping the absorption wavelength of the photoelectric converter 1032. This increases the material options for the first diffusion reducer 102.

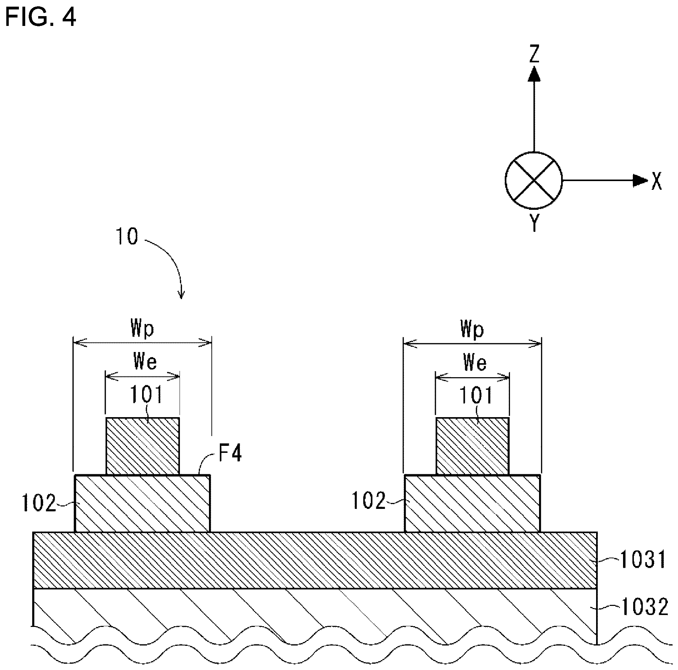

In a plan view of the light-receiving surface F1 of the solar cell device 10, the first portion A1 of the first diffusion reducer 102 may have a width Wp larger than a width We of the first electrode 101. In other words, in a cross section perpendicular to the longitudinal direction of the electrode (FIG. 4) when the light-receiving surface F1 of the solar cell device 10 is viewed from above, the width Wp of the first portion A1 of the first diffusion reducer 102 may be larger than the width We of the first electrode 101. The width Wp may be the width of the second surface F4 of the first diffusion reducer 102.

This structure can reduce the likelihood that the molecules on the side surfaces of the first electrode 101 fall and diffuse into the solar cell unit 103, compared with when the width Wp of the first portion A1 of the first diffusion reducer 102 and the width We of the first electrode 101 are the same. Thus, the solar cell device 10 can have less conversion efficiency reduction.

The width Wp of the first portion A1 of the first diffusion reducer 102 may be the sum of the width We of the first electrode 101 and a predetermined width. The predetermined width may be determined based on the positional accuracy for forming the first electrode 101. For example, the predetermined width may be determined to be greater than an error in forming the first electrode 101. The first electrode 101 may be formed with an error in either the left or right direction. Thus, the predetermined width may be at least twice the error in forming the first electrode 101.

The width Wp of the first portion A1 of the first diffusion reducer 102 may be determined based on the width We of the first electrode 101. For example, the width Wp of the first portion A1 of the first diffusion reducer 102 may be smaller than the width We of the first electrode 101 by about 100 nm to 100 micrometers (µm) inclusive. When, for example, the width We of the first electrode 101 is 10 to 100 µm inclusive, the width Wp of the first portion A1 of the first diffusion reducer 102 may be larger than the width We of the first electrode 101 by about 10 to 100 µm inclusive. For example, the width Wp of the first portion A1 of the first diffusion reducer 102 may be larger than 100% of the width We of the first electrode 101 and smaller than or equal to 200% of the width We of the first electrode 101.

Note that the first electrode 101 may be displaced to the left or right of the first portion A1 of the first diffusion reducer 102. In other words, in FIG. 4, the center line of the first electrode 101 in a lateral direction may deviate from the center line of the first portion A1 of the first diffusion reducer 102 in the lateral direction. In other words, in FIG. 4, the distance from the left end of the first electrode 101 to the left end of the first portion A1 of the first diffusion reducer 102 may differ from the distance from the right end of the first electrode 101 to the right end of the first portion A1 of the first diffusion reducer 102.

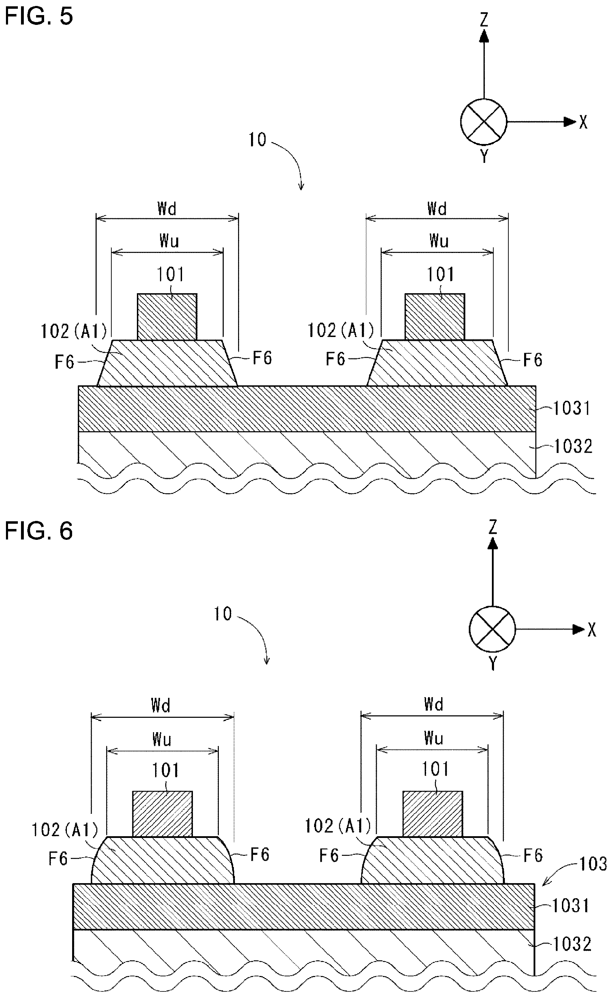

Note that, in the first embodiment, the first portion A1 of the first diffusion reducer 102 has a rectangular cross section. However, the shape of the cross section of the first portion A1 of the first diffusion reducer 102 is not limited to a rectangle. Various cross sections of the first portion A1 of the first diffusion reducer 102 will now be described with reference to FIGs. 5 to 9.

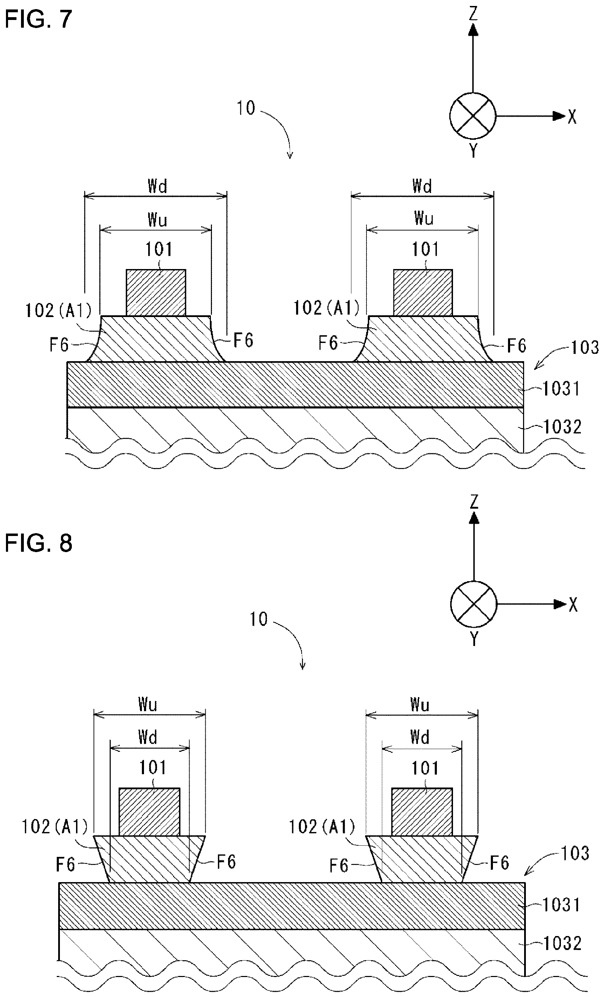

For example, in the cross section of the first portion A1 of the first diffusion reducer 102, the surface in contact with the solar cell unit 103 may have a width Wd lager than a width Wu of the surface in contact with the first electrode 101, as illustrated in FIGs. 5 to 7. More specifically, the first portion A1 may include the first surface F3 with the width Wd larger than the width Wu of the second surface F4. In other words, the cross section of the first portion A1 of the first diffusion reducer 102 may have a larger area in contact with the solar cell unit 103 than in contact with the first electrode 101 as illustrated in FIGs. 5 to 7. In this structure, the first diffusion reducer 102 has the center of gravity near the solar cell unit 103, thus having higher structural stability. In this case, the first portion A1 of the first diffusion reducer 102 may have a trapezoidal cross section as illustrated in FIG. 5. The first portion A1 of the first diffusion reducer 102 may also have a dome-shaped cross section as illustrated in FIG. 6. In other words, the first portion A1 includes a fourth surface F6 as a side surface that may be curved in an arc shape with its center included in the first diffusion reducer 102. The first portion A1 of the first diffusion reducer 102 may have a cross section flaring toward the bottom as illustrated in FIG. 7. In other words, the fourth surface F6 of the first portion A1 may be curved in an arc shape with its center outside the first diffusion reducer 102 in an X-direction.

For example, in the cross section of the first portion A1 of the first diffusion reducer 102, the width Wd adjacent to the solar cell unit 103 may be smaller than the width Wu adjacent to the first electrode 101 as illustrated in FIG. 8. This structure increases a light-receiving area of the solar cell unit 103, improving the conversion efficiency of the solar cell device 10.

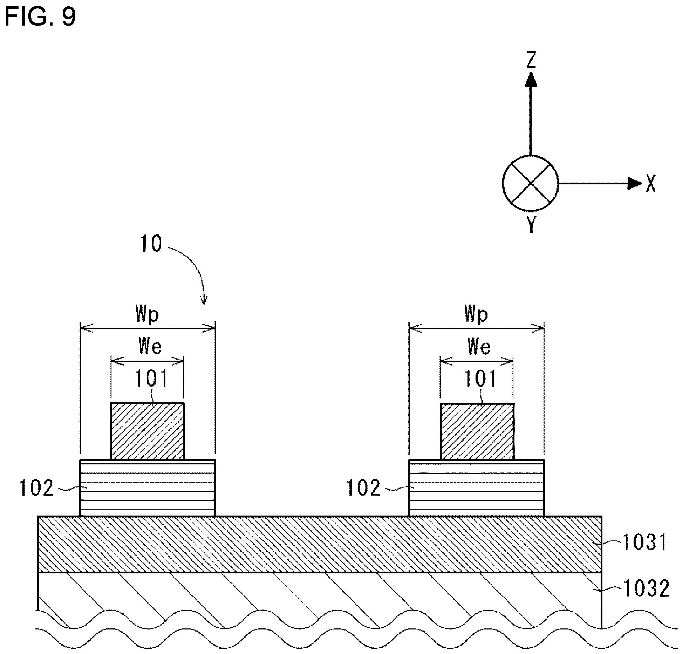

The material for the first diffusion reducer 102 may include a material with an absorption wavelength overlapping the absorption wavelength of the photoelectric converter 1032, when the width Wp of the first portion A1 of the first diffusion reducer 102 is larger than the width We of the first electrode 101 in a plan view of the light-receiving surface F1 of the solar cell device 10 as illustrated in FIG. 9.

Note that, in FIGs. 5 to 8, the fourth surface F6 refers to a surface of the first portion A1 connecting the first surface F3 and the second surface F4. The fourth surface F6 is different from the third surface F5. The fourth surface F6 may be flat or curved. The fourth surface F6 may be regarded as a set of surfaces connecting the first surface F3 and the second surface F4 of the first portion A1.

The first electrode 101 may have a lower specific resistance than the solar cell unit 103. The specific resistance of the first diffusion reducer 102 may be less than or equal to the specific resistance of the solar cell unit 103 and greater than or equal to the specific resistance of the first electrode 101. In this case, the specific resistance of the first diffusion reducer 102 may be less than or equal to the specific resistance of the first carrier transporter 1031 and greater than or equal to the specific resistance of the first electrode 101. The specific resistances that are set as above change stepwise from the solar cell unit 103 to the first electrode 101, reducing an increase in the resistance. In this case, the specific resistance of the first diffusion reducer 102 may be determined by the material selected for the first diffusion reducer 102 or the film deposition conditions adjusted for the first diffusion reducer 102. Note that the specific resistance may be a specific electrical resistance, an electrical resistance, or a resistance. The unit of specific resistance is, for example, ohm-meter (Ω·m).

### 1-1-5. First Electrode 101

The first electrode 101 is located on the first diffusion reducer 102. More specifically, the first electrode 101 is located on the second surface F4 of the first diffusion reducer 102.

The first electrode 101 can collect carriers resulting from photoelectric conversion in response to light incident on the photoelectric converter 1032. The first electrode 101 can serve as, for example, an electrode that collects holes as carriers (also referred to as a positive electrode). The first electrode 101 may serve as, for example, a current-collecting electrode.

The material for the first electrode 101 may be, for example, a highly conductive metal such as Ag, Au, Cu, Ti, In, or Sn. The first electrode 101 may be formed on the first diffusion reducer 102 with, for example, a vacuum process such as sputtering. The first electrode 101 may have an average thickness ranging from, for example, 1 to 50 µm inclusive, but the thickness is not limited to such values.

The first electrode 101 may be formed by, for example, applying a metal paste as a coating liquid by, for example, screen printing and drying the applied metal paste until the metal paste solidifies. The metal paste may be prepared by, for example, adding highly light-reflective and electrically conductive particles to a binder such as a light-transmissive resin. The light-transmissive resin may be, for example, an epoxy resin. The particles contained in the metal paste may be, for example, metal particles of an alloy of Ag and Cu, Al, Ni, or Zn. In this case, the first electrode 101 includes many conductive particles, which may provide the conductivity of the first electrode 101. The first electrode 101 may be, for example, a layer.

The shape of the first electrode 101 is not limited to the shape illustrated in FIGs. 1 to 3 in the first embodiment. The shapes of the first electrode 101 and the first diffusion reducer 102 may be altered as appropriate to improve carrier collection efficiency. The first electrode 101 and the first diffusion reducer 102 may have, for example, the shape of an interdigital electrode or the shape of busbar electrodes and finger electrodes being combined.

The first electrode 101 and the second electrode 104 are each electrically connected to, for example, a lead wire. More specifically, for example, the first electrode 101 is electrically connected to a first lead wire, and the second electrode 104 is electrically connected to a second lead wire. The lead wires may be bonded respectively to the first electrode 101 and the second electrode 104 by, for example, soldering. The first lead wire and the second lead wire can receive, for example, outputs resulting from photoelectric conversion in the solar cell device 10.

### 1-1-6. Method for Manufacturing Solar Cell Device 10

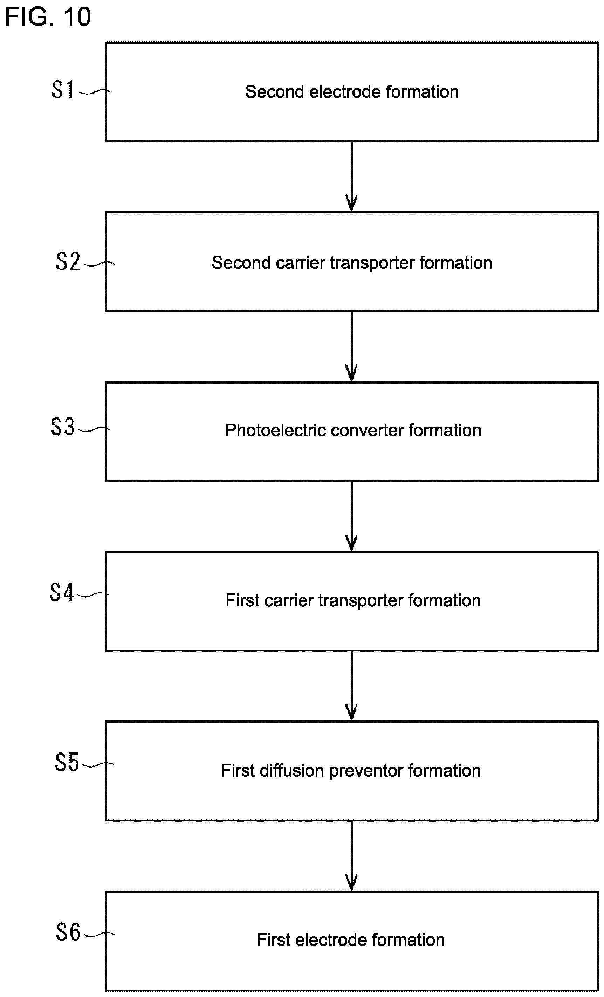

For example, as illustrated in FIG. 10, the solar cell device 10 according to the first embodiment can be manufactured through the processing in steps S1 to S5 performed in this order.

In step S1, the second electrode 104 is formed on the substrate 105. In this step, the second electrode 104 can be formed on the substrate 105 by, for example, depositing the material for the second electrode 104 on the substrate 105 with a vacuum process such as sputtering. The material for the second electrode 104 may be, for example, a highly conductive metal such as Au, or a TCO such as ITO, FTO, or ZnO.

In step S2, the second carrier transporter 1033 is formed on the second electrode 104. The material for the second carrier transporter 1033 may be, for example, a metal oxide such as TiO₂, SnO₂, ZnO, or In2O₃. In this step, for example, the second carrier transporter 1033 may be formed on the second electrode 104 by applying, onto the second electrode 104, a liquid material prepared by dissolving a material such as metal chloride or metal isopropoxide into a polar solution, and hydrolyzing the material to produce a metal oxide. Examples of the metal chloride include titanium chloride, tin chloride, zinc chloride, and indium chloride. Examples of the metal isopropoxide include titanium isopropoxide, tin isopropoxide, zinc isopropoxide, and indium isopropoxide. More specifically, for example, a titanium tetrachloride solution is applied onto the second electrode 104 with, for example, spin coating and then dried. The titanium tetrachloride is then hydrolyzed with, for example, heat at about 150 °C on a hot plate to form the second carrier transporter 1033 made of TiO₂ on the second electrode 104.

For example, the material for the second carrier transporter 1033 may be, for example, an organic material. The organic material may be, for example, a fullerene derivative such as PCBM. In this case, the material may be a liquid material prepared by dissolving the fullerene derivative into a chlorobenzene solvent to contain about 5 to 20 milligrams (mg) of the fullerene derivative in 1 milliliter (1 ml) of the liquid material. In other words, for example, a liquid material containing chlorobenzene as a solvent and a fullerene derivative at a concentration of about 5 to 20 mg/ml is used. The second carrier transporter 1033 made of PCBM may be formed on the second electrode 104 by drying and annealing the liquid material applied on the second electrode 104. For example, for the organic material used as the material for the second carrier transporter 1033, the functional group may be changed to change the physical properties and solubility in organic solvents.

In step S3, the photoelectric converter 1032 is formed on the second carrier transporter 1033. In this step, the photoelectric converter 1032 may be formed by, for example, applying a liquid material onto the second carrier transporter 1033 and annealing the applied liquid material. The liquid material may be prepared by, for example, dissolving alkyl halide amine and lead halide as the materials for the photoelectric converter 1032 in the solvent or dissolving alkyl halide amine and tin halide as the materials for the photoelectric converter 1032 in the solvent. In this case, the photoelectric converter 1032 may be a thin film of a crystalline halide perovskite semiconductor.

In step S4, the first carrier transporter 1031 is formed on the photoelectric converter 1032. In this step, the first carrier transporter 1031 can be formed on the photoelectric converter 1032 by, for example, applying a liquid material onto the photoelectric converter 1032 and drying and annealing the liquid material. The material for the first carrier transporter 1031 may be, for example, an organic semiconductor material such as spiro-OMeTAD, P3HT, PTAA, or Poly-TPD. For example, the liquid material can be prepared by dissolving spiro-OMeTAD in chlorobenzene to contain about 10 to 85 mg of spiro-OMeTAD in 1 ml of the liquid material. In other words, for example, a liquid material containing chlorobenzene as a solvent and spiro-OMeTAD at a concentration of about 10 to 85 mg/ml is used. For example, the liquid material may be prepared by dissolving P3HT in dichlorobenzene to contain about 5 to 20 mg of P3HT in 1 ml of the liquid material. In other words, for example, a liquid material containing dichlorobenzene as a solvent and P3HT at a concentration of about 5 to 20 mg/ml may be used. For example, the liquid material may be prepared by dissolving PTAA in toluene to contain about 5 to 20 mg of PTAA in 1 ml of the liquid material. In other words, for example, a liquid material containing toluene as a solvent and PTAA at a concentration of 5 to 20 mg/ml may be used. For example, the liquid material may be prepared by dissolving Poly-TPD in chlorobenzene to contain about 5 to 20 mg of Poly-TPD in 1 ml of the liquid material. In other words, for example, a liquid material containing chlorobenzene as a solvent and Poly-TPD at a concentration of 5 to 20 mg/ml may be used.

In step S5, the first diffusion reducer 102 is formed on the first carrier transporter 1031. The first electrode 101 can be formed on the first carrier transporter 1031 by, for example, depositing the material for the first diffusion reducer 102 on the first carrier transporter 1031 with a vacuum process such as sputtering. The material for the first diffusion reducer 102 is, for example, a TCO such as ITO, FTO, or ZnO.

In step S5, a vacuum process and mask patterning may be performed in combination to form the first portion A1 and the second portion A2 of the first diffusion reducer 102. For example, the first portion A1 of the first diffusion reducer 102 may be formed by masking a portion to be the second portion A2 and depositing the material for the first diffusion reducer 102 on the first carrier transporter 1031. For example, the second portion A2 of the first diffusion reducer 102 may be formed by depositing the material for the first diffusion reducer 102 on the entire surface of the first carrier transporter 1031 and etching the portion to be the second portion A2. The etching may be performed with a plasma gas, a laser, or a liquid chemical.

In step S6, the first electrode 101 is formed on the first diffusion reducer 102. For example, the first electrode 101 is formed on the surface of the first diffusion reducer 102 facing away from the first carrier transporter 1031. In this step, the first electrode 101 can be formed on the first diffusion reducer 102 by depositing the material for the first electrode 101 on the first diffusion reducer 102 with, for example, a vacuum process such as sputtering. The material for the first electrode 101 is, for example, a highly conductive metal such as Au or a TCO such as ITO, FTO, or ZnO. The first electrode 101 may be formed by, for example, applying a metal paste as a coating liquid by, for example, screen printing and drying the applied metal paste until the metal paste solidifies.

### 1-2. Solar Cell Module 1

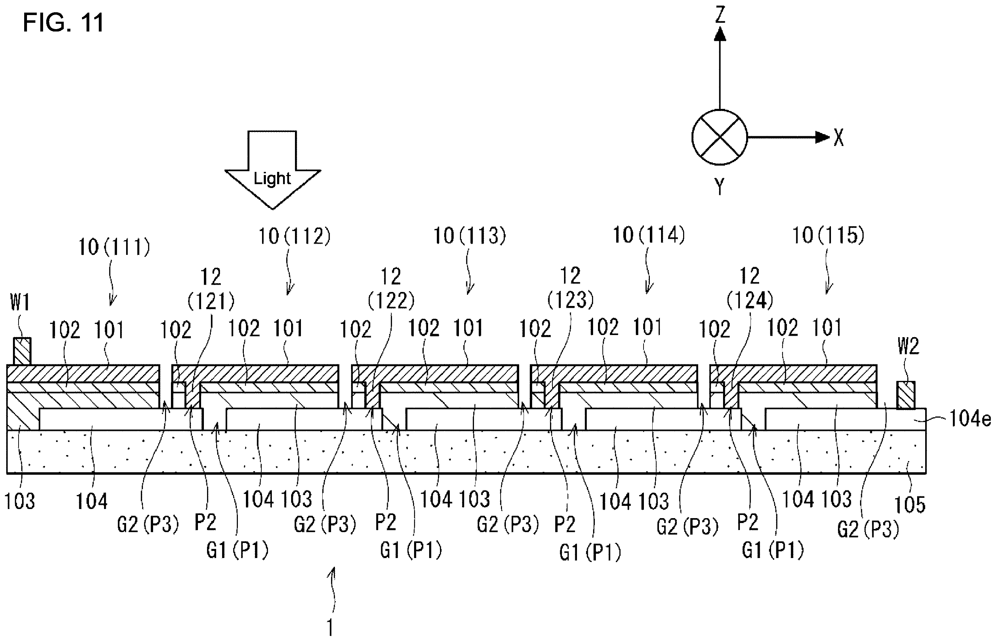

As illustrated in, for example, FIG. 11, the solar cell module 1 includes multiple solar cell devices 10 on the single substrate 105. In other words, the multiple solar cell devices 10 share the substrate 105. In this structure, the substrate 105 can support and protect the multiple solar cell devices 10. The substrate 105 is, for example, a flat plate with a rectangular plate surface. The material for the substrate 105 is, for example, glass, or a resin such as an acrylic resin or a polycarbonate resin. Examples of the glass include white plate glass, tempered glass, and heat-reflective glass with high light transmittance.

The multiple solar cell devices 10 are aligned in a planar manner in the positive X-direction as a first direction. Being aligned in a planar manner refers to the state in which the multiple solar cell devices 10 are located along an imaginary plane or a physical plane side by side. In the first embodiment, the multiple solar cell devices 10 are aligned on the substrate 105 along the surface of the substrate 105.

More specifically, for example, the multiple solar cell devices 10 may include five solar cell devices 10 aligned on the substrate 105 in the first direction (positive X-direction). The five solar cell devices 10 include, for example, a first solar cell device 111, a second solar cell device 112, a third solar cell device 113, a fourth solar cell device 114, and a fifth solar cell device 115 aligned in sequence in the positive X-direction. More specifically, the multiple solar cell devices 10 include an n-th solar cell device 11n (where n is a natural number from 1 to 5).

In the first embodiment, each of the solar cell devices 10 is strip-shaped and is elongated in the positive Y-direction. Each of the solar cell devices 10 includes the first electrode 101, the first diffusion reducer 102, the solar cell unit 103, and the second electrode 104.

In the first embodiment, five second electrodes 104 are sequentially aligned on the substrate 105 in the positive X-direction in a planar manner. The second electrode 104 in an m-th solar cell device 11m (m is a natural number from 1 to 4) and the second electrode 104 in a (m + 1)th solar cell device 11(m + 1) are aligned across a space (also referred to as a first space) G1. For example, the second electrode 104 in the first solar cell device 111 and the second electrode 104 in the second solar cell device 112 are aligned across the space (first space) G1. The first space G1 is elongated in the positive Y-direction. A first groove P1 is also defined by the substrate 105 as a bottom surface and facing end faces of two second electrodes 104 adjacent to each other across the first space G1 as side surfaces.

In the first embodiment, five first electrodes 101 are aligned sequentially in a planar manner in the positive X-direction. The first electrode 101 in the m-th solar cell device 11m and the first electrode 101 in the (m + 1)th solar cell device 11(m + 1) are aligned across a space (also referred to as a second space) G2. For example, the first electrode 101 in the first solar cell device 111 and the first electrode 101 in the second solar cell device 112 are aligned with the space (second space) G2. The second space G2 is, for example, elongated in the positive Y-direction. A third groove P3 is also defined with the second electrode 104 as a bottom surface. In each of the solar cell devices 10, the second electrode 104 protrudes in the positive X-direction more than the first electrode 101. In other words, the first space G1 is shifted further in the first direction (positive X-direction) than the second space G2.

Adjacent ones of the solar cell devices 10 are electrically connected in series by a connector 12. In the first embodiment, an m-th connector 12m electrically connects the m-th solar cell device 11m and the (m + 1)th solar cell device 11(m + 1). For example, a first connector 121 electrically connects the first solar cell device 111 and the second solar cell device 112. More specifically, the m-th connector 12m electrically connects the second electrode 104 in the m-th solar cell device 11m and the first electrode 101 in the (m + 1)th solar cell device 11(m + 1). For example, the first connector 121 electrically connects the second electrode 104 in the first solar cell device 111 and the first electrode 101 in the second solar cell device 112. Thus, the multiple solar cell devices 10 may be electrically connected in series.

The connector 12 is located between portions of the solar cell unit 103 in the positive X-direction. In other words, the portions of the solar cell unit 103 as side surfaces and the surface of the second electrode 104 in the negative Z-direction as the bottom surface define a second groove P2. The second groove P2 is elongated in the positive Y-direction. For example, the second groove P2 receives the connector 12. In this structure, the connector 12 may be a portion of the first electrode 101 filling the second groove P2.

Note that, in the first solar cell device 111, the first electrode 101 includes a first protrusion 101e protruding in the negative X-direction more than the first diffusion reducer 102, the solar cell unit 103, and the second electrode 104. In the fifth solar cell device 115, the second electrode 104 includes a second protrusion 104e protruding in the positive X-direction more than the first electrode 101, the first diffusion reducer 102, and the solar cell unit 103. The first protrusion 101e is electrically connected to a first conductor W1 with a first polarity for output. The second protrusion 104e is electrically connected to a second conductor W2 with a second polarity for output. When, for example, the first polarity is negative, the second polarity is positive. Note that, when the first polarity is positive, for example, the second polarity is negative.

### 2. Other Embodiments

The present disclosure is not limited to the first embodiment, but may be changed or varied variously without departing from the spirit and scope of the present disclosure.

### Second Embodiment

A second embodiment will now be described focusing on its differences from the first embodiment.

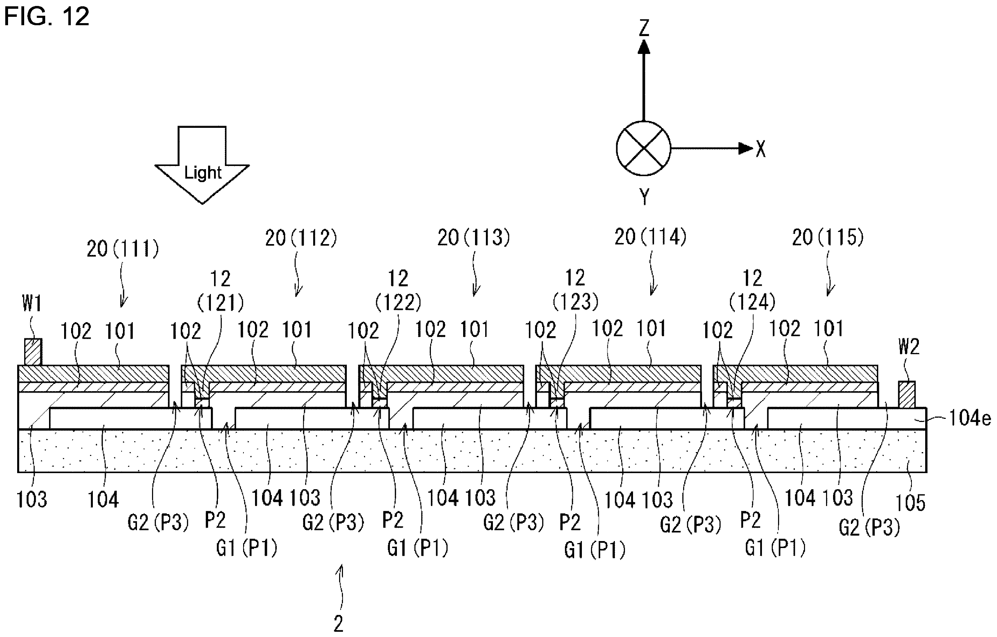

FIG. 12 is a cross-sectional view of a solar cell module 2 according to the second embodiment in the positive Y-direction. In the second embodiment, the solar cell module 2 and solar cell devices 20 further include the first diffusion reducer 102 between the connector 12 (first electrode 101) and the second electrode 104 in the second groove P2.

This structure reduces the area of contact between the side surface of the connector 12 (first electrode 101) and the side surface of the solar cell unit 103, thus reducing the likelihood of the first electrode 101 deteriorating by coming in contact with the solar cell unit 103 or the solar cell unit 103 deteriorating by coming in contact with the first electrode 101.

### Third Embodiment

A third embodiment will now be described focusing on its differences from the first embodiment.

FIG. 13 is a cross-sectional view of a solar cell device 30 according to the third embodiment, taken perpendicular to the longitudinal direction of the electrode when the light-receiving surface F1 is viewed from above. In the solar cell device 30 according to the third embodiment, a second portion A2 of the first diffusion reducer 102 has a thickness other than zero. Note that, in the solar cell device 10 according to the first embodiment, the second portion A2 of the first diffusion reducer 102 has no thickness. In the third embodiment, the first diffusion reducer 102 includes a first portion A1 with a third thickness and the second portion A2 with a fourth thickness smaller than the third thickness. In other words, the first diffusion reducer 102 may be regarded as including a first layer with the fourth thickness on the solar cell unit 103 and a second layer formed in the first portion A1 on the first layer as a protrusion. The second layer has a thickness that is a difference between the third thickness and the fourth thickness. In this case, the material for the first diffusion reducer 102 is a TCO such as ITO, FTO, or ZnO. The thickness of the first diffusion reducer 102 may be, for example, about 10 to 1000 nm. The third thickness may be, for example, about 1 to 100 nm larger than the fourth thickness.

This structure including the conductive first diffusion reducer 102 located on the first carrier transporter 1031 in the solar cell unit 103 allows the first electrode 101 to collect carriers from the first carrier transporter 1031 more efficiently. Thus, the solar cell device 10 has higher conversion efficiency.

In the third embodiment, the vacuum process and mask patterning may be combined in step S5 in the first embodiment to form the first portion A1 and the second portion A2 of the first diffusion reducer 102. For example, the second portion A2 of the first diffusion reducer 102 may be formed by depositing the material for the first diffusion reducer 102 on the entire surface of the first carrier transporter 1031 and etching a portion to be the second portion A2. The etching may be performed with a plasma gas, a laser, or a liquid chemical.

### Fourth Embodiment

A fourth embodiment will now be described focusing on its differences from the third embodiment.

FIG. 14 is a cross-sectional view of a solar cell device 40 according to a fourth embodiment, taken perpendicular to the longitudinal direction of the electrode when the light-receiving surface F1 is viewed from above. In the fourth embodiment, the solar cell device 40 further includes a second diffusion reducer 106 between the first diffusion reducer 102 and the solar cell unit 103 (first carrier transporter 1031). More specifically, the second diffusion reducer 106 is located between the first diffusion reducer 102 and the solar cell unit 103. In other words, in the fourth embodiment, the solar cell device 40 may be regarded as having the structure in which the second diffusion reducer 106 is located between the first diffusion reducer 102 and the solar cell unit 103 (first carrier transporter 1031) in the solar cell device 10 according to the first embodiment. In other words, in the fourth embodiment, the solar cell device 40 may be regarded as having the structure in which the first diffusion reducer 102 in the solar cell device 30 according to the third embodiment is separated to a portion between the second surface F4 and the third surface F5 and a portion between the third surface F5 and the first surface F3.

The structure of the solar cell device 40 according to the fourth embodiment will be described in detail. The second diffusion reducer 106 is located on the light-receiving surface F1 of the solar cell unit 103. The second diffusion reducer 106 includes a fifth surface F7 in contact with the light-receiving surface F1 of the solar cell unit 103 and a sixth surface F8 opposite to the fifth surface F7. The first diffusion reducer 102 is located on the sixth surface F8 of the second diffusion reducer 106. The first surface F3 of the first diffusion reducer 102 is in contact with the sixth surface F8 of the second diffusion reducer 106.

The second diffusion reducer 106 may cover the entire light-receiving surface F1 of the solar cell unit 103. In this case, in a plan view of the light-receiving surface F1 of the solar cell device 40, the first diffusion reducer 102 or the first electrode 101 is viewed in the first portion A1 of the first diffusion reducer 102, whereas, in a plan view of the light-receiving surface F1 of the solar cell device 10, the sixth surface F8 of the second diffusion reducer 106 is viewed in the second portion A2 of the first diffusion reducer 102. More specifically, in a plan view of the light-receiving surface F1 of the solar cell device 40, the sixth surface F8 of the second diffusion reducer 106 is exposed in the second portion A2 of the first diffusion reducer 102.

In the solar cell device 40 according to the fourth embodiment, the first diffusion reducer 102 and the second diffusion reducer 106 may have different specific resistances. For example, the specific resistance of the second diffusion reducer 106 may be greater than or equal to the specific resistance of the first diffusion reducer 102. The specific resistance of the second diffusion reducer 106 may be greater than the specific resistance of the first diffusion reducer 102. This structure allows the carrier density to change stepwise from the second diffusion reducer 106 to the first diffusion reducer 102, thus reducing an increase in resistance resulting from band mismatching. In this structure, the specific resistances of the first diffusion reducer 102 and the second diffusion reducer 106 may be determined by the materials selected for the first diffusion reducer 102 and the second diffusion reducer 106 or the film deposition conditions adjusted for the first diffusion reducer 102 and the second diffusion reducer 106.

The first diffusion reducer 102 and the second diffusion reducer 106 may be made of the same type of material. In this case, the first diffusion reducer 102 and the second diffusion reducer 106 may be made of the same type of element or a combination of elements of the same type. More specifically, the elements in the first diffusion reducer 102 and the second diffusion reducer 106 may be the same. The material for the first diffusion reducer 102 and the second diffusion reducer 106 is, for example, a TCO such as ITO, FTO, or ZnO. In this case, the first diffusion reducer 102 and the second diffusion reducer 106 may have different carrier densities. More specifically, the first diffusion reducer 102 may have a higher carrier density than the second diffusion reducer 106. Typically, TCOs have a trade-off between conductivity (carrier density) and transmittance. With the first diffusion reducer 102 below the first electrode 101 receiving no light, the first diffusion reducer 102 with lower transmittance is less likely to affect the conversion efficiency of the solar cell device 40. The conversion efficiency of the solar cell device 40 can be improved by increasing the conductivity of the first diffusion reducer 102 to reduce the resistance loss in the first diffusion reducer 102. In this case, the carrier densities of the first diffusion reducer 102 and the second diffusion reducer 106 may be determined by the film deposition conditions adjusted for the first diffusion reducer 102 and the second diffusion reducer 106.

The first diffusion reducer 102 and the second diffusion reducer 106 may be made of different materials. More specifically, the element in the first diffusion reducer 102 is different from the element in the second diffusion reducer 106. For example, the material for the second diffusion reducer 106 may be a TCO such as ITO, FTO, or ZnO, whereas the material for the first diffusion reducer 102 may be an electrically conductive inorganic material such as a conductive oxide, in addition to the TCO. With the first diffusion reducer 102 below the first electrode 101 receiving no light, the first diffusion reducer 102 with lower transmittance is less likely to affect the conversion efficiency of the solar cell device 40. Thus, the material for the first diffusion reducer 102 is not to be transmissive to the absorption wavelength of the solar cell unit 103, whereas the material for the second diffusion reducer 106 is to be transmissive to the absorption wavelength of the solar cell unit 103. More specifically, the first diffusion reducer 102 and the second diffusion reducer 106 made of different materials can increase the material options for the first diffusion reducer 102.

In the fourth embodiment, the second diffusion reducer 106 is formed between step S4 and step S5 in the first embodiment.

The second diffusion reducer 106 is formed on the first carrier transporter 1031 in the solar cell unit 103. The second diffusion reducer 106 can be formed on the first carrier transporter 1031 by, for example, depositing the material for the second diffusion reducer 106 on the first carrier transporter 1031 with a vacuum process such as sputtering.

### Fifth Embodiment

A fifth embodiment will now be described focusing on its differences from the first embodiment. In the fifth embodiment, a solar cell device 50 is, for example, a multi-junction solar cell, a tandem solar cell, a multilayered solar cell, or a stacked solar cell. More specifically, in the fifth embodiment, the solar cell device as a multi-junction solar cell includes thin-film solar cells joined to one another. A combination of thin-film solar cells may be a combination of perovskite solar cells or a combination of a perovskite solar cell and another thin-film solar cell such as a silicon thin-film solar cell.

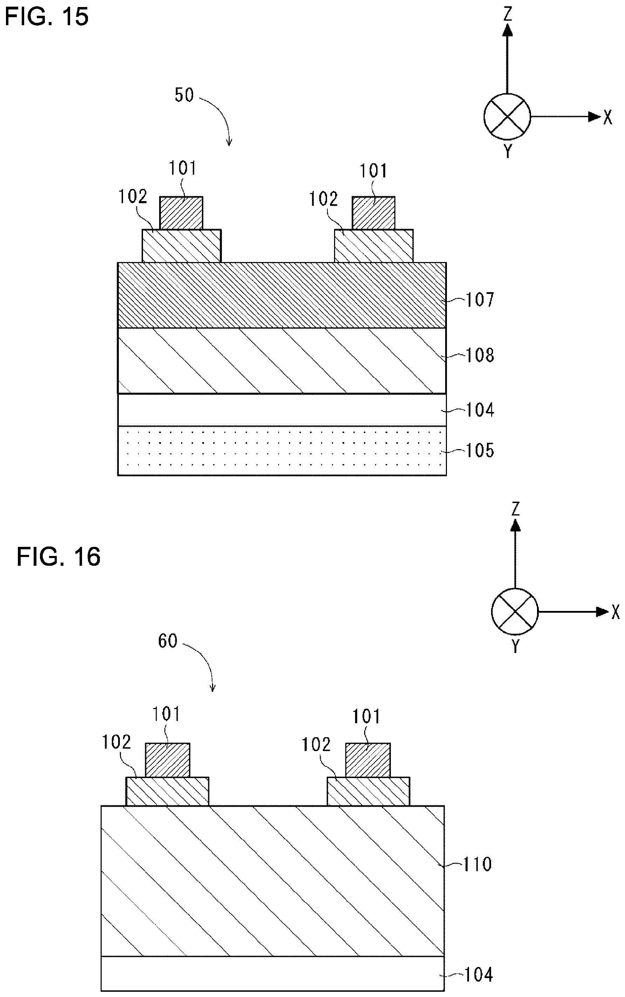

FIG. 15 is a cross-sectional view of a solar cell device 50 according to the fifth embodiment, taken perpendicular to the longitudinal direction of the first electrode 101 when the light-receiving surface F1 is viewed from above. In the fifth embodiment, the solar cell device 50 further includes a second solar cell unit 108 in addition to a first solar cell unit 107. In the fifth embodiment, the second electrode 104, the second solar cell unit 108, the first solar cell unit 107, the first diffusion reducer 102, and the first electrode 101 are stacked in this order on the substrate 105. Note that, in the fifth embodiment as well, the first diffusion reducer 102 may have the structure described in the third embodiment or the fourth embodiment.

The first solar cell unit 107 converts external light (e.g., sunlight) incident on the first solar cell unit 107 to electric power. For example, the solar cell unit 103 may generate carriers through photoelectric conversion in response to light illumination. The carriers include electrons, holes, or both. The first solar cell unit 107 may be a perovskite solar cell or other solar cells. For example, the solar cell may be an inorganic solar cell or an organic solar cell. The inorganic solar cell may be a silicon solar cell or a compound solar cell. The organic solar cell may be a dye-sensitized solar cell or an organic thin-film solar cell. As in the first embodiment, the first solar cell unit 107 includes a first carrier transporter 1031, a photoelectric converter 1032, and a second carrier transporter 1033.

The material for the first solar cell unit 107 transmits light with the absorption wavelength of the second solar cell unit 108. This structure may allow light with the absorption wavelength of the second solar cell unit 108 to be incident on the second solar cell unit 108.

The second solar cell unit 108 converts external light (e.g., sunlight) incident on the second solar cell unit 108 to electric power. The second solar cell unit 108 has an absorption wavelength different from the absorption wavelength of the first solar cell unit 107. The second solar cell unit 108 may have a longer absorption wavelength than the first solar cell unit 107. Note that the absorption wavelength may include a wavelength band, in addition to a single wavelength. For example, the absorption wavelength may be a wavelength band such as a visible light range or a wavelength band from a first wavelength to a second wavelength.

The second solar cell unit 108 may be a perovskite solar cell or other solar cells. For example, the solar cell may be an inorganic solar cell or an organic solar cell. The inorganic solar cell may be a silicon solar cell or a compound solar cell. The organic solar cell may be a dye-sensitized solar cell or an organic thin-film solar cell. As in the first embodiment, the second solar cell unit 108 includes a first carrier transporter 1031, a photoelectric converter 1032, and a second carrier transporter 1033.

The multiple solar cell units 103, including the first solar cell unit 107 and the second solar cell unit 108, stacked on each other in this structure are connected in series. The solar cell device 50 can thus have higher power output and have higher conversion efficiency.

Although not illustrated in FIG. 15, the solar cell device 50 according to the fifth embodiment may further include a buffer (not illustrated) between the first solar cell unit 107 and the second solar cell unit 108. The buffer connects the first solar cell unit 107 and the second solar cell unit 108. The buffer transmits light with the absorption wavelength of the second solar cell unit 108.

Note that, although the two-layered multi-junction solar cell device is illustrated in FIG. 15, the solar cell device 50 is not limited to this structure. For example, the solar cell device 50 may be a multi-junction solar cell device including two or more layers.

### Sixth Embodiment

A sixth embodiment will now be described focusing on its differences from the first embodiment. In a solar cell device 60 according to the sixth embodiment, the solar cell unit 103 is a crystalline solar cell. In other words, in the sixth embodiment, the solar cell device 60 may be regarded as including a crystalline solar cell as the solar cell unit 103 in the solar cell device 10 according to the first embodiment.

### 6-1. Solar Cell Device 60

FIG. 16 is a cross-sectional view of the solar cell device 60 according to the sixth embodiment, taken perpendicular to the longitudinal direction of the first electrode 101 when the light-receiving surface F1 is viewed from above. In the sixth embodiment, the solar cell device 60 includes a third solar cell unit 110. In the sixth embodiment, the second electrode 104, the third solar cell unit 110, the first diffusion reducer 102, and the first electrode 101 are stacked in this order. Note that, in the sixth embodiment as well, the first diffusion reducer 102 may have the structure described in the second embodiment or the third embodiment.

The third solar cell unit 110 is a solar cell including silicon crystals. The third solar cell unit 110 can use light incident on the silicon crystals to generate electric power through photoelectric conversion. The silicon crystals may be a single crystal of silicon or polycrystals of silicon. The third solar cell unit 110 may be a p-n junction solar cell or a p-i-n junction solar cell.

Note that the third solar cell unit 110 made of silicon crystals is rigid, and thus can serve as the substrate 105. Thus, the solar cell device 60 may not include the substrate 105.

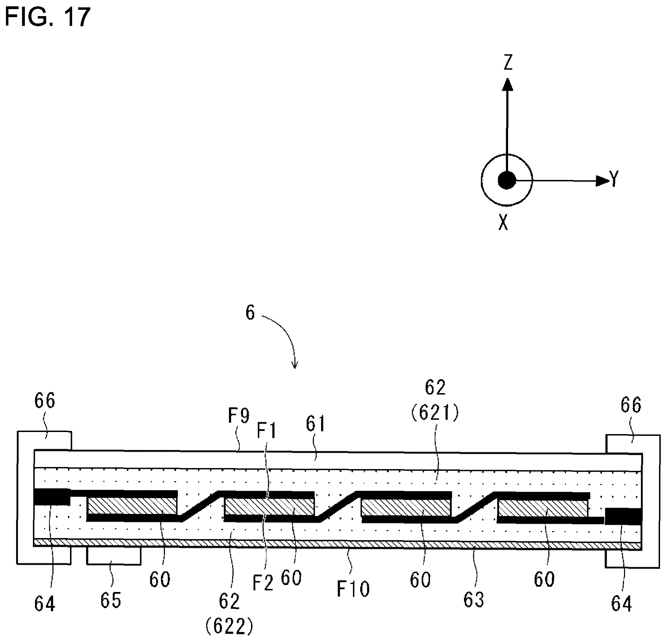

As illustrated in FIG. 17, multiple solar cell devices 60 are located between a first protective member 61 and a second protective member 63. The multiple solar cell devices 60 are arrayed in a planar manner along a module front surface F9 of the first protective member 61. In the example in FIG. 17, the multiple solar cell devices 60 are aligned two-dimensionally along an imaginary XY plane.

### 6-2. Solar Cell Module 6

As illustrated in FIG. 17, the solar cell module 6 includes, for example, the module front surface F9 that mainly receives sunlight and a module back surface F10 opposite to the module front surface F9. The module front surface F9 is a surface of the solar cell module 6 adjacent to the light-receiving surfaces F1 of the solar cell devices 60. The module back surface F10 is a surface of the solar cell module 6 adjacent to the back surfaces F2 of the solar cell devices 60.

For example, the module front surface F9 faces in the positive Z-direction. For example, the module back surface F10 faces in the negative Z-direction. When the solar cell module 6 is used, for example, outdoors for power generation, the positive Z-direction is, for example, set to a direction toward the sun culminating in the south.

As illustrated in FIG. 17, for example, the solar cell module 6 includes the multiple solar cell devices 60, the first protective member 61, and a seal 62. The solar cell module 6 further includes the second protective member 63.

The solar cell module 6 may further include, for example, a terminal box 65 for outputting the generated power. The terminal box 65 is located on, for example, the module back surface F10.

The solar cell module 6 may further include, for example, a frame 66 for protecting the outer periphery of the solar cell module 6. The frame 66 is located along, for example, the outer periphery of the solar cell module 6. In this structure, for example, the solar cell module 6 may further include a seal 62 with lower moisture permeability, such as a butyl resin, filling the space between the outer periphery and the frame 66.

### 6-2-1. First Protective Member 61

The first protective member 61 protects, for example, the areas of the solar cell devices 60 adjacent to the module front surface F9. The first protective member 61 is, for example, part of the module front surface F9. The first protective member 61 is, for example, light-transmissive. More specifically, the first protective member 61 transmits, for example, light with the wavelengths in a specific range. The wavelengths in the specific range include, for example, the wavelength of light that can be photoelectrically converted by the solar cell devices 60. When the wavelengths in the specific range include a wavelength of sunlight with high radiation intensity, the solar cell module 6 can have higher photoelectric conversion efficiency. The first protective member 61 may be, for example, a sheet or a film. The material for the first protective member 61 may be, for example, a weather-resistant fluororesin. Examples of the weather-resistant fluorine resin include fluorinated ethylene propylene (FEP), ethylene tetrafluoroethylene (ETFE), and ethylene chlorotrifluoroethylene

### (ECTFE).

### 6-2-2. Seal 62

The seal 62 covers, for example, the solar cell devices 60. For example, the seal 62 fills an area between the first protective member 61 and the second protective member 63 and covers the solar cell devices 60 between the first protective member 61 and the second protective member 63. The seal 62 includes, for example, a portion adjacent to the module front surface F9 (also referred to as a first seal 621) and a portion adjacent to the module back surface F10 (also referred to as a second seal 622). The first seal 621 covers, for example, the entire surface of each of the solar cell devices 60 facing the first protective member 61. In other words, the first seal 621 covers, for example, the solar cell devices 60 between the first protective member 61 and the solar cell devices 60. The second seal 622 covers, for example, the entire surface of each of the solar cell units 103 facing the second protective member 63. In other words, the second seal 622 covers, for example, the solar cell devices 60 between the second protective member 63 and the solar cell devices 60. Thus, the solar cell devices 60 are, for example, sandwiched and surrounded by the first seal 621 and the second seal 622. The seal 62 can thus, for example, maintain the orientation of the solar cell devices 60.

The seal 62 is, for example, light-transmissive. The seal 62 transmits, for example, light with wavelengths in the specific range described above. For example, when at least the first seal 621, among the first seal 621 and the second seal 622 included in the seal 62, is light transmissive, light incident on the module front surface F9 may reach the solar cell devices 60. For example, the material for the first seal 621 and the material for the second seal 622 are each a resin. More specifically, the material for the first seal 621 is, for example, ethylenevinyl acetate (EVA) copolymer, polyvinyl acetal such as polyvinyl butyral (PVB), or an acid-modified resin. For example, the first seal 621 made of EVA, which is relatively inexpensive, can easily achieve protection of the multiple solar cell devices 60. The acid-modified resin is, for example, a modified polyolefin resin formed by, for example, graphitically modifying a polyolefin resin with an acid. The material for the second seal 622 may be, for example, EVA, polyvinyl acetal such as PVB, or an acid-modified resin, in the same manner as or in a similar manner to the material for the first seal 621. Each of the first seal 621 and the second seal 622 may be made of, for example, two or more different materials.

The solar cell panel may further include a gasket (not illustrated) along a looped portion of an area between the first protective member 61 and the second protective member 63 open to the external space. In this case, the gasket surrounds, for example, the outer periphery of an area including the solar cell devices 60 and the seal 62 between the first protective member 61 and the second protective member 63. The gasket fills, for example, the area from the first protective member 61 to the second protective member 63. When, for example, the gasket has lower moisture permeability than the seal 62, the gasket can seal the portion of the area between the first protective member 61 and the second protective member 63 along the outer periphery. Thus, the gasket can reduce, for example, moisture entering the solar cell devices 60 from outside the solar cell module 6. The material for the gasket may be, for example, a butyl resin, a polyisopropylene resin, or an acrylic resin. The material for the gasket may be, for example, a material with low moisture permeability, including a metal such as copper or solder and a nonmetal such as glass.

### 6-2-3. Second Protective Member 63

The second protective member 63 protects, for example, the area of the solar cell devices 60 adjacent to the module back surface F10. The second protective member 63 is, for example, part of the module back surface F10. The second protective member 63 may or may not be light-transmissive. The second protective member 63 may be, for example, a sheet or a flat plate. The sheet may be, for example, a back sheet to be the module back surface F10. The material for the back sheet may be, for example, a resin.

### 6-2-4. Current Collector 64

A current collector 64 serves as an output electrode. The current collector 64 is, for example, an aluminum wire or a copper wire. The current collector 64 is connected to a terminal for receiving electricity generated in the solar cell module 6.

### Seventh Embodiment

A seventh embodiment will now be described focusing on its differences from the sixth embodiment. In the seventh embodiment, a solar cell device 70 is, for example, a multi-junction solar cell, a tandem solar cell, a multilayer solar cell, or a stacked solar cell. For example, the solar cell device 70 in the seventh embodiment may include a crystalline solar cell and a thin-film solar cell stacked on each other. More specifically, in the seventh embodiment, the solar cell device 70 includes a silicon crystalline solar cell and a perovskite solar cell joined to each other. For example, in the seventh embodiment, the solar cell device 70 as a multi-junction solar cell may include a silicon crystalline solar cell and a perovskite solar cell stacked on the silicon crystalline solar cell.

In other words, in the seventh embodiment, the solar cell device 70 may be regarded as having the structure in which the third solar cell unit 110 is located between the solar cell unit 103 and the second electrode 104 in the solar cell device 10 according to the first embodiment. In the seventh embodiment, the solar cell device 70 may also be regarded as having the structure in which the second solar cell unit 108 is replaced with the third solar cell unit 110 in the solar cell device 50 according to the fifth embodiment. In the seventh embodiment, the solar cell device 70 may also be regarded as having the structure in which the first solar cell unit 107 is located between the first diffusion reducer 102 and the third solar cell unit 110 in the solar cell device 60 according to the sixth embodiment.

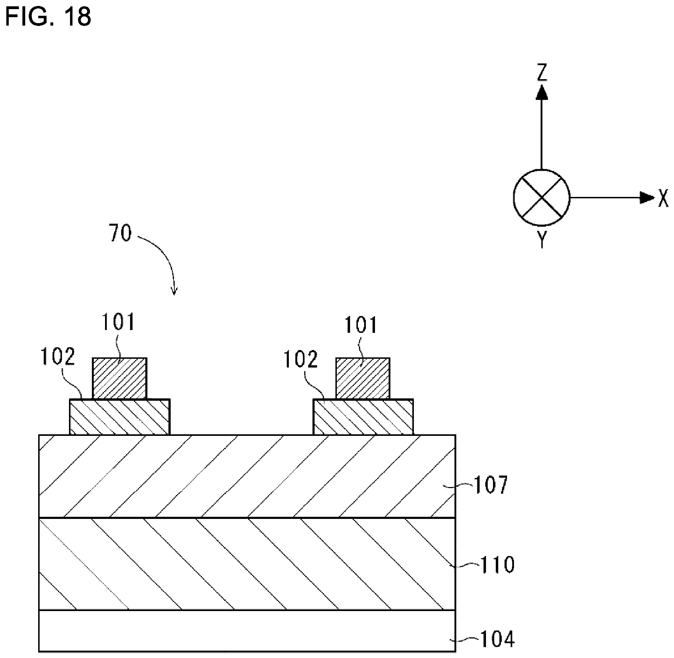

FIG. 18 is a cross-sectional view of the solar cell device 70 according to the seventh embodiment, taken perpendicular to the longitudinal direction of the first electrode 101 when the light-receiving surface F1 is viewed from above. In the seventh embodiment, the solar cell device 70 further includes the third solar cell unit 110 in addition to the first solar cell unit 107. In other words, in the seventh embodiment, the solar cell device 70 includes the second electrode 104, the third solar cell unit 110, the first solar cell unit 107, the first diffusion reducer 102, and the first electrode 101 stacked in this order. Note that, in the seventh embodiment as well, the first diffusion reducer 102 may have the structure described in the second embodiment or the third embodiment.

In the seventh embodiment, the structure may also include a buffer (not illustrated) between the first solar cell unit 107 and the third solar cell unit 110.

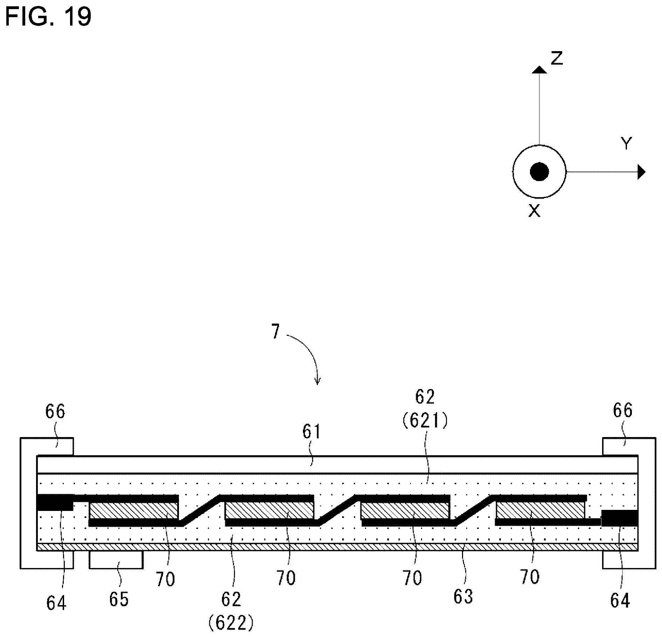

As illustrated in FIG. 19, in the seventh embodiment, a solar cell module 7 may have the structure in which the solar cell devices 60 in the solar cell module 6 according to the sixth embodiment are replaced with solar cell devices 70 according to the seventh embodiment.

### Other Embodiments

Although the present disclosure has been described based on the drawings and embodiments, those skilled in the art should be aware that various variations and alterations may be made based on the present disclosure. These variations and alterations are thus intended to fall within the scope of the present disclosure. For example, the functions of the components and the steps are reconfigurable unless any contradiction arises logically. Multiple components or steps may be combined into a single unit or step, or a single component or step may be divided into separate units or steps. Each of the embodiments of the present disclosure described above is not limited to its faithful implementation, and may be implemented by combining the features or eliminating some features as appropriate. Overview of Present Disclosure

The present disclosure provides the structures described below.

In one embodiment, (1) a solar cell device may include a solar cell unit including a light-receiving surface, an electrode, and a first diffusion reducer between the solar cell unit and the electrode. The first diffusion reducer may include a first surface on the light-receiving surface and a second surface on the electrode. In a plan view of the light-receiving surface, the first diffusion reducer may be located in an area other than at least part of an area not overlapping the electrode.

In one embodiment, (2) a solar cell device may include a solar cell unit including a light-receiving surface, an electrode, and a first diffusion reducer between the solar cell unit and the electrode. The first diffusion reducer may include a first surface on the light-receiving surface, a second surface on the electrode, and a third surface opposite to the first surface. The third surface may be located in at least part of an area not overlapping the electrode in a plan view of the light-receiving surface. The first diffusion reducer may have a smaller thickness between the first surface and the third surface than between the first surface and the second surface.

(3) In the solar cell device according to (1) or (2), the second surface may have a larger width than the electrode in a direction perpendicular to a longitudinal direction of the electrode when the light-receiving surface is viewed from above.

(4) In the solar cell device according to any one of (1) to (3), in a cross-sectional view taken perpendicular to a longitudinal direction of the electrode when the light-receiving surface is viewed from above, the first diffusion reducer may include a first portion with a thickness from the first surface to the second surface, and a width of the first portion adjacent to the first surface may be larger than a width of the first portion adjacent to the second surface.

(5) In the solar cell device according to any one of (1) to (4), the first diffusion reducer may further include a second diffusion reducer between the first diffusion reducer and the solar cell unit.

(6) In the solar cell device according to any one of (1) to (5), the second diffusion reducer may have a specific resistance greater than or equal to a specific resistance of the first diffusion reducer.

(7) In the solar cell device according to any one of (1) to (6), the second diffusion reducer and the first diffusion reducer may contain a same element, and the second diffusion reducer may have a lower carrier density than the first diffusion reducer.

(8) In the solar cell device according to any one of (1) to (7), the solar cell unit may include a semiconductor with a perovskite structure.

In one embodiment, (9) a solar cell module may include a solar cell unit including a light-receiving surface, a first diffusion reducer on the light-receiving surface and including a first surface in contact with the light-receiving surface, a second surface opposite to the first surface, and a third surface different from the second surface, and an electrode on the second surface. The first diffusion reducer may include a first portion having a thickness from the first surface to the second surface, and a second portion having a thickness from the first surface to the third surface. The second portion may have a smaller thickness than the first portion.

(10) In the solar cell module according to (9), the third surface may be aligned with the first surface, instead of being parallel to the first surface.

(11) In the solar cell module according to (9) or (10), the first portion may have a larger width than the electrode in a direction perpendicular to a longitudinal direction of the electrode when the light-receiving surface is viewed from above.

(12) In the solar cell module according to any one of (9) to (11), in a cross-sectional view taken perpendicular to a longitudinal direction of the electrode when the light-receiving surface is viewed from above, a width of the first portion adjacent to the first surface may be larger than a width of the first portion adjacent to the second surface.

(13) In the solar cell module according to any one of (9) to (12), the first diffusion reducer may further include a second diffusion reducer between the first diffusion reducer and the solar cell unit.

(14) In the solar cell module according to any one of (9) to (13), the second diffusion reducer may have a specific resistance greater than or equal to a specific resistance of the first diffusion reducer.

(15) In the solar cell module according to any one of (9) to (14), the second diffusion reducer and the first diffusion reducer may contain a same element, and the second diffusion reducer may have a lower carrier density than the first diffusion reducer.

(16) In the solar cell module according to any one of (9) to (15), the solar cell unit may include a semiconductor with a perovskite structure.

### REFERENCE SIGNS

1 solar cell module
10 solar cell device
101 first electrode
102 first diffusion reducer
103 solar cell unit
1031 first carrier transporter
1032 photoelectric converter
1033 second carrier transporter
104 second electrode
105 substrate
106 second diffusion reducer
107 first solar cell unit
108 second solar cell unit
109 buffer
110 third solar cell unit
111 first solar cell device
112 second solar cell device
113 third solar cell device
114 fourth solar cell device
115 fifth solar cell device
12 connector
121 first connector
122 second connector
123 third connector
124 fourth connector
2 solar cell module
20 solar cell device
3 solar cell module
30 solar cell device
4 solar cell module
40 solar cell device
5 solar cell module
50 solar cell device
6 solar cell module
60 solar cell device
61 first protective member
62 seal
621 first seal
622 second seal
63 second protective member
64 current collector
65 terminal box
66 frame
7 solar cell module
70 solar cell device
F1 light-receiving surface
F2 back surface
F3 first surface
F4 second surface
F5 third surface
F6 fourth surface
F7 fifth surface
F8 sixth surface
F9 module front surface
F10 module back surface
A1 first portion
A2 second portion
G1 first space
G2 second space
P1 first groove
P2 second groove
P3 third groove
T1 first thickness
T2 second thickness
T3 third thickness
T4 fourth thickness

## Claims

1. A solar cell device, comprising:
a solar cell unit including a light-receiving surface;
an electrode; and
a first diffusion reducer between the solar cell unit and the electrode,
wherein the first diffusion reducer includes a first surface on the light-receiving surface and a second surface on the electrode, and
in a plan view of the light-receiving surface, the first diffusion reducer is located in an area other than at least part of an area not overlapping the electrode.

2. A solar cell device, comprising:
a solar cell unit including a light-receiving surface;
an electrode; and
a first diffusion reducer between the solar cell unit and the electrode,
wherein the first diffusion reducer includes
a first surface on the light-receiving surface,
a second surface on the electrode, and
a third surface opposite to the first surface, the third surface being located in at least part of an area not overlapping the electrode in a plan view of the light-receiving surface, and
the first diffusion reducer has a smaller thickness between the first surface and the third surface than between the first surface and the second surface.

3. The solar cell device according to claim 1 or claim 2, wherein
the second surface has a larger width than the electrode in a direction perpendicular to a longitudinal direction of the electrode when the light-receiving surface is viewed from above.

4. The solar cell device according to any one of claims 1 to 3, wherein
in a cross-sectional view taken perpendicular to a longitudinal direction of the electrode when the light-receiving surface is viewed from above, the first diffusion reducer includes a first portion with a thickness from the first surface to the second surface, and a width of the first portion adjacent to the first surface is larger than a width of the first portion adjacent to the second surface.

5. The solar cell device according to any one of claims 1 to 4, further comprising:
a second diffusion reducer between the first diffusion reducer and the solar cell unit.

6. The solar cell device according to claim 5, wherein
the second diffusion reducer has a specific resistance greater than or equal to a specific resistance of the first diffusion reducer.

7. The solar cell device according to claim 5 or claim 6, wherein
the second diffusion reducer and the first diffusion reducer comprise a same element, and
the second diffusion reducer has a lower carrier density than the first diffusion reducer.

8. The solar cell device according to any one of claims 1 to 7, wherein
the solar cell unit includes a semiconductor with a perovskite structure.

9. A solar cell module, comprising:
a solar cell unit including a light-receiving surface;
a first diffusion reducer on the light-receiving surface, the first diffusion reducer including a first surface in contact with the light-receiving surface, a second surface opposite to the first surface, and a third surface different from the second surface; and
an electrode on the second surface,
wherein the first diffusion reducer includes a first portion having a thickness from the first surface to the second surface, and a second portion having a thickness from the first surface to the third surface, and
the second portion has a smaller thickness than the first portion.
